# EUROPEAN PATENT APPLICATION

(11) **EP 4 749 486 A1**
(43) Date of publication of application: **27.05.2026**
(21) Application number: 24844228.7
(22) Date of filing: 29.02.2024
(51) Int. Cl.: G06F 18/241

(54) **EARLY-WARNING METHOD AND APPARATUS, AND NETWORK DEVICE, ELECTRIC ENERGY DEVICE AND MEDIUM**

(30) Priority: 21.07.2023 CN 202310905195
(71) Applicant: BYD Company Limited, Shenzhen, Guangdong 518118 (CN)
(72) Inventor: FENG, Tianyu, Shenzhen, Guangdong 518118 (CN); ZHANG, Pengqing, Shenzhen, Guangdong 518118 (CN); DENG, Linwang, Shenzhen, Guangdong 518118 (CN)
(74) Representative: Taor, Simon Edward William
(86) International application number: PCT/CN2024/079298
(87) International publication number: WO 2025/020530

(57) **Abstract**

An early warning method and apparatus, a network device, an electric energy device, and a medium are provided, and relate to the field of battery technologies. The method includes: performing correlation analysis on sample production data and sample operation fault data of a preset subcomponent sample to obtain production fault correlation data; when the production fault correlation data is greater than a predetermined threshold, determining an early warning indicator based on the sample production data corresponding to the sample operation fault data; and then obtaining a historical production data feature of a subcomponent during production, and when the historical production data feature of the subcomponent matches the early warning indicator, issuing early warning prompt information.

## Description

### CROSS-REFERENCE TO RELATED APPLICATIONS

The present disclosure claims priority to Chinese Patent Application No. 202310905195.3, filed on July 21, 2023 and entitled "EARLY WARNING METHOD AND APPARATUS, NETWORK DEVICE, ELECTRIC ENERGY DEVICE, AND MEDIUM", which is incorporated herein by reference in its entirety.

### TECHNICAL FIELD

The present disclosure relates to the field of battery technologies, and in particular, to an early warning method and apparatus, a network device, an electric energy device, and a medium.

### BACKGROUND

In manufacturing, when production of device subcomponents is completed, various tests are usually performed to distinguish between a qualified subcomponent and an unqualified subcomponent. For example, in a related technology in the power battery industry, to distinguish between a faulty battery and a qualified battery, relevant parameters of the batteries need to be tested upon completion of battery production to screen out a faulty battery whose relevant parameters are outside a standard range, and a battery whose relevant parameters are within the standard range is identified as the qualified battery. However, even when the qualified battery in the related technology is used, some unexpected faults may still occur. When the qualified battery in the related technology fails in use, a common processing manner is as follows: recycling all batteries in a same batch or all electric devices using the batteries in the same batch and identifying the batteries in the same batch as faulty batteries; or only processing the faulty batteries. It can be learned that in the related technology, for a battery or an electric energy device that actually has a potential fault risk but has not yet exhibited any anomaly, a conventional technology cannot provide a timely early warning in advance.

### SUMMARY

Implementations of this specification are intended to resolve one of the technical problems in the related technology at least to some extent. Therefore, implementations of this specification provide an early warning method and apparatus, a network device, an electric energy device, and a medium.

Implementations of this specification provide an early warning method for a device, where the device includes a subcomponent, and the method includes:
obtaining a historical production data feature of the subcomponent during production; and
when the historical production data feature of the subcomponent matches an early warning indicator, issuing early warning prompt information, where
the early warning indicator is created by: obtaining production fault correlation data based on sample production data and sample operation fault data of a preset subcomponent sample, and when the production fault correlation data is greater than a predetermined threshold, determining the early warning indicator based on the sample production data corresponding to the sample operation fault data, where there are a plurality of preset subcomponent samples.

In one of the implementations, when the historical production data feature of the subcomponent matches the early warning indicator, early warning prompt information is issued to the subcomponent, so that potential problems of the subcomponent can be effectively found and an early warning can be issued.

In one of the implementations, the device is an electric energy device, the subcomponent is a battery, and the preset subcomponent sample is a preset sample battery. Before performing correlation analysis on the sample production data and the sample operation fault data of the preset subcomponent sample, the method further includes:
obtaining actual sample production data of the preset sample battery during production, where the actual sample production data corresponds to expected sample production data; and
determining abnormal production data from the actual sample production data as the sample production data based on a comparison result between the actual sample production data and the expected sample production data.

In one of the implementations, a method for determining the abnormal production data includes at least one of the following steps:
determining the actual sample production data different from the expected sample production data as the abnormal production data; or
determining the actual sample production data whose difference from the expected sample production data exceeds a preset difference threshold range as the abnormal production data.

In one of the implementations, performing correlation analysis on the sample production data and the sample operation fault data of preset subcomponent sample includes:
performing feature extraction on the abnormal production data to obtain a target production data feature; and
performing correlation analysis on the target production data feature and the sample operation fault data to obtain the production fault correlation data.

In one of the implementations, after performing feature extraction on the abnormal production data, the method further includes:
performing feature extraction on the abnormal production data to obtain an abnormal production data feature; and
screening out the abnormal production data feature that meets a first preset screening condition as the target production data feature.

In one of the implementations, before performing correlation analysis on the sample production data and the sample operation fault data of the preset subcomponent sample, the method further includes:
obtaining a sample operation fault data feature from a sample fault trace database as the sample operation fault data.

In one of the implementations, a method for constructing the sample fault trace database includes:
obtaining an operation data feature of faulty batteries during operation, where the faulty battery is the preset sample battery on which a fault occurs during operation;
screening out the operation data feature that meets a second preset screening condition as the sample operation fault data feature; and
storing the sample operation fault data feature into the sample fault trace database.

In one of the implementations, obtaining the operation data feature of the faulty battery during operation includes:
obtaining initial operation data of the faulty battery during operation;
performing data cleaning on the initial operation data to obtain target operation data; and
performing feature extraction on the target operation data to obtain the operation data feature.

In one of the implementations, after obtaining the target production data feature, the method further includes:
performing classification processing on the target production data feature to obtain a classified abnormal data feature; and
after obtaining the sample operation fault data feature, the method includes:
   performing classification processing on the sample operation fault data feature to obtain a classified fault data feature; and
   performing correlation analysis on the classified abnormal data feature and the classified fault data feature to obtain the production fault correlation data.

In one of the implementations, an analysis method for performing correlation analysis to obtain the production fault correlation data includes at least one of clustering, variance analysis, and proportion statistics.

An implementation of this specification provides an early warning method, applied to a network device, for an electric energy device, where the electric energy device includes a battery, and the method includes:
obtaining a historical production data feature of the battery during production; and
matching the historical production data feature with an early warning indicator, and when the matching is successful, issuing a corresponding early warning signal to the electric energy device, so that the electric energy device issues early warning prompt information based on the early warning signal; and a method for creating the early warning indicator includes:
   performing correlation analysis on sample production data and sample operation fault data of a preset sample battery to obtain production fault correlation data, where there are a plurality of preset sample batteries; and
   when the production fault correlation data is greater than a predetermined threshold, determining an early warning indicator based on the sample production data corresponding to the sample operation fault data.

An implementation of this specification provides an early warning method applied to an electric energy device, where the electric energy device includes a battery, and the method includes:
receiving an early warning signal sent by a network device, and issuing corresponding early warning prompt information based on the early warning signal, where the early warning signal is determined by the network device based on a matching status between a historical production data feature of the battery and an early warning indicator, and a method for creating the early warning indicator includes:
performing correlation analysis on sample production data and sample operation fault data of a preset sample battery to obtain production fault correlation data, where there are a plurality of preset sample batteries; and
when the production fault correlation data is greater than a predetermined threshold, determining an early warning indicator based on the sample production data corresponding to the sample operation fault data.

An implementation of this specification provides an early warning method applied to an electric device, where the electric device includes a battery, the electric device stores a historical production data feature of the battery, and the method includes:
receiving an early warning indicator sent by a network device; and
matching the historical production data feature with the early warning indicator, and when the matching is successful, issuing corresponding early warning prompt information; and
a method for creating the early warning indicator includes:
   performing correlation analysis on sample production data and sample operation fault data of a preset sample battery to obtain production fault correlation data, where there are a plurality of preset sample batteries; and
   when the production fault correlation data is greater than a predetermined threshold, determining an early warning indicator based on the sample production data corresponding to the sample operation fault data.

An implementation of this specification provides a network device, including a memory and a processor. The memory stores a computer program. When the processor executes the computer program, the method according to any one of the foregoing implementations is implemented.

An implementation of this specification provides an electric energy device, including a memory and a processor. The memory stores a computer program, and when the processor executes the computer program, the early warning method according to any one of the foregoing implementations is implemented.

In one of the implementations, the electric energy device is a vehicle, a ship, or an aircraft.

An implementation of this specification provides a computer-readable storage medium. When instructions in the computer-readable storage medium are executed by a processor of an electronic device, the electronic device is enabled to perform the method according to any one of the foregoing implementations.

An implementation of this specification provides a computer program product, including a computer program. When the computer program is executed by the processor, the method according to any one of the foregoing implementations is implemented.

An implementation of this specification provides an early warning apparatus for a battery, where the apparatus includes:
a production feature obtaining module, configured to obtain an actual production data feature of a to-be-evaluated battery during production; and
an early warning prompt issuing module, configured to issue early warning prompt information when the actual production data feature of the to-be-evaluated battery matches an early warning indicator, where a method for creating the early warning indicator includes:
   performing correlation analysis on sample production data and sample operation fault data of a preset sample battery to obtain production fault correlation data, where there are a plurality of preset sample batteries; and
   when the production fault correlation data is greater than a predetermined threshold, determining an early warning indicator based on the sample production data corresponding to the sample operation fault data.

An implementation of this specification provides an early warning apparatus for a vehicle, where the vehicle includes a power battery, and the apparatus includes:
a production feature obtaining module, configured to obtain a historical production data feature of the power battery during production; and
an early warning prompt issuing module, configured to: match the historical production data feature with an early warning indicator, and when the matching is successful, issue a corresponding early warning signal to the vehicle, to enable the vehicle to issue early warning prompt information based on the early warning signal; and a method for creating the early warning indicator includes:
   performing correlation analysis on sample production data and sample operation fault data of a preset sample battery to obtain production fault correlation data, where there are a plurality of preset sample batteries; and
   when the production fault correlation data is greater than a predetermined threshold, determining an early warning indicator based on the sample production data corresponding to the sample operation fault data.

In the foregoing implementations of this specification, correlation analysis is performed on the sample production data and the sample operation fault data of the preset subcomponent sample to obtain the production fault correlation data. When the production fault correlation data is greater than the predetermined threshold, the early warning indicator is determined based on the sample production data corresponding to the sample operation fault data. Then, the historical production data feature of the subcomponent during production is obtained. When the historical production data feature of the subcomponent matches the early warning indicator, the early warning prompt information is issued. When part of device subcomponents is faulty, by matching the early warning indicator with the historical production data feature of the device subcomponents, the device subcomponent that does not exhibit any anomaly but has a potential fault risk can be determined, and the early warning prompt information can be issued. Further, the created early warning indicator may be further used to guide a production process of the device subcomponent, thereby enhancing quality of the device subcomponent.

### BRIEF DESCRIPTION OF DRAWINGS

The foregoing and/or additional aspects and advantages of the present disclosure will become apparent and readily understood from the description of embodiments taken with reference to the following accompanying drawings, in which:
FIG. 1a is a diagram of an application scenario of a method for creating a battery production early warning indicator according to an implementation of this specification;
FIG. 1b is a schematic flowchart of an early warning method for a device according to an implementation of this specification;
FIG. 2 is a schematic flowchart for determining sample production data according to an implementation of this specification;
FIG. 3 is a schematic flowchart for determining production fault correlation data according to an implementation of this specification;
FIG. 4a is a schematic flowchart for determining a target production data feature according to an implementation of this specification;
FIG. 4b is a diagram of a battery voltage and a battery current according to an implementation of this specification;
FIG. 4c is a diagram of a battery temperature and a battery current according to an implementation of this specification;
FIG. 4d is a diagram of a battery capacity and a battery current according to an implementation of this specification;
FIG. 5a is a schematic flowchart for determining an operation data feature according to an implementation of this specification;
FIG. 5b is a diagram of a battery cell voltage according to an implementation of this specification;
FIG. 5c is a diagram of a battery cell voltage according to an implementation of this specification;
FIG. 6 is a schematic flowchart for determining production fault correlation data according to an implementation of this specification;
FIG. 7 is a pie chart showing statistical proportions of fault type data features and battery production data abnormal features according to an implementation of this specification;
FIG. 8 is a schematic flowchart of a method for determining a production early warning indicator according to an implementation of this specification;
FIG. 9 is a schematic flowchart of an early warning method for a vehicle according to an implementation of this specification;
FIG. 10 is a schematic flowchart of an early warning method for a vehicle according to an implementation of this specification;
FIG. 11 is a schematic flowchart of a method for creating a battery production early warning indicator according to an implementation of this specification;
FIG. 12 is a diagram of an apparatus for creating a battery production early warning indicator according to an implementation of this specification;
FIG. 13 is a diagram of an early warning apparatus for a battery according to an implementation of this specification;
FIG. 14 is a diagram of an early warning apparatus for a vehicle according to an implementation of this specification;
FIG. 15 is a diagram of an early warning apparatus for a vehicle according to an implementation of this specification;
FIG. 16 is a diagram of an early warning apparatus for a battery according to an implementation of this specification; and
FIG. 17 is a diagram of an early warning apparatus for a vehicle according to an implementation of this specification.

### DESCRIPTION OF EMBODIMENTS

Embodiments of the present disclosure are described in detail below, examples of which are shown in the accompanying drawings, where same or similar reference numerals throughout represent same or similar elements or elements having same or similar functions. The embodiments described below with reference to the accompanying drawings are exemplary. For example, a manufacturing process in the power battery industry is taken as an example for analysis, and an indicator creating process is illustrated taking a production early warning indicator as an example. These are intended to explain the present disclosure, and shall not be construed as a limitation on the present disclosure.

In manufacturing, when product production is completed, various tests are usually performed to distinguish between a qualified product and an unqualified product. However, even if a product is delivered from the factory as the qualified product for use after production tests are performed, there may still be some potential fault risks. For these products having the potential risks, a conventional technology cannot provide an early warning. For ease of understanding, the following takes a battery as an example to describe implementations of the present disclosure.

Under urgent need for energy conservation and emission reduction across society, developing a new energy vehicle that is environmentally friendly or has an energy-saving advantage has become a consensus in the vehicle industry. Electric vehicles, as a main direction of new energy vehicle development, have always been a hot topic of concern to the whole society in terms of their safety and stability. Frequent power battery safety accidents cause losses to lives and property of people. Therefore, it is necessary to provide strong insurance for safety and stability of power batteries through comprehensive and rigorous process optimization methods and accurate and effective fault early warning methods.

In a related technology, a battery production process is monitored, and early warnings are sent for some abnormal production situations, so that a power battery fault can be prevented in advance. However, a monitoring method used in the battery production process in the related technology does not detect abnormal production situations related to a battery operation fault.

An electrochemical process involved in the battery production process operates under smooth and uniform conditions, with a battery in a quasi-steady state, and at this stage, various parameters of the battery are determined. Therefore, initial quality of the battery depends on the battery production process. Furthermore, the initial quality of the battery is correlated to some extent with an operation fault that occurs after the battery is installed in a vehicle. Through further analysis of the inventors, it is found that because the initial quality of the battery depends on the battery production process, and actual production data is generated in the battery production process. Therefore, based on mining of actual production data, an abnormal feature exhibited in the actual production data is indeed a root cause of the operation fault that occurs after the battery is installed in the vehicle.

Based on this, an implementation of this specification provides a method for creating the early warning indicator. Specifically, first, sample production data and sample operation fault data of a sample battery are obtained, and correlation analysis is performed on the obtained sample production data and the obtained sample operation fault data to obtain production fault correlation data. It should be noted that there are a plurality of sample batteries, and there may be a plurality of types of the sample operation fault data. Second, the production fault correlation data is compared with a predetermined threshold. When the production fault correlation data is greater than the predetermined threshold, the sample operation fault data corresponding to the production fault correlation data can be determined, and then the early warning indicator is determined based on the sample production data corresponding to the sample operation fault data. It should be noted that the sample operation fault data in the implementation of the present application means data obtained from a fault that occurs during later normal operation of a product that is delivered from the factory as the qualified product.

An implementation of this specification further provides a scenario example to illustrate a method for creating the early warning indicator. First, a target production data feature used to characterize deviation of actual production data of a battery from expected production data of the battery during battery production and an operation fault data feature correlated with a fault type during operation of a faulty battery are obtained. Then, correlation analysis is performed based on the target production data feature and the operation fault data feature to obtain production fault correlation data that describes a degree of correlation between the target production data feature and the fault type. Finally, the early warning indicator correlated with the fault type is obtained through mining from the target production data feature based on the production fault correlation data. By determining the early warning indicator more correlated with the fault type, when a production data feature corresponding to the early warning indicator is exhibited during battery production, an early warning prompt can be sent accurately and in a timely manner for an abnormal production situation correlated with a battery operation fault. Alternatively, when the battery has passed tests but have not been installed in the vehicle for use, and the battery is still at a warehouse storage stage, a transportation stage, or the like, as long as the production data feature corresponding to the early warning indicator is exhibited during battery production, early warning prompt information can be sent to the battery. It should be understood that for a battery having an early warning prompt function, the battery itself can issue prompt information. For a battery without the early warning prompt function, the early warning prompt information can be directly issued by, for example, a server or another compute terminal. The early warning prompt information includes identity information, location information, batch information, or the like of the battery.

Further, on one hand, an abnormal production situation of a battery in production is prompted, to reduce delivery of an unqualified battery, and enhance battery safety. On the other hand, for a battery that has been delivered from the factory and is in use, the early warning indicator can be used to analyze actual production data of the battery in use, to provide an accurate early warning for a battery fault. It should be noted that the faulty battery in the implementation of the present application means a battery that has passed quality tests upon the completion of production but is faulty during subsequent use, and does not mean an unqualified battery that has been faulty in quality inspection upon the completion of production.

This scenario example further provides an early warning method that is for a device and that combines the foregoing early warning indicator correlated with the operation fault type. The device may be an electric energy device. The electric energy device may be a vehicle, a ship, or an aircraft. In this scenario, a vehicle is used as an example.

In a related technology, by obtaining historical operation data generated by a battery during operation of the vehicle, a data feature correlated with an operation fault can be mined, and unsupervised learning and supervised learning methods can be used together to train an operation fault early warning model, and complete early warning of the battery operation fault. However, because the battery is a complex electrochemical system with a high nonlinear degree, and is affected by road conditions and a driving environment, vehicle operating conditions are complex and changeable. This leads to significant noise in historical operation data of the vehicle battery, which is not conducive to mining and extracting an operation data feature correlated with a fault. Therefore, a method for early warning of the vehicle battery fault by only using historical operation data of a battery also needs to be improved.

For a battery that has been delivered from the factory and is in operation in the vehicle, when the battery in the vehicle exhibits the operation fault data feature correlated with the operation fault type during operation, it may be further determined, in combination with actual production data of the power battery in the vehicle, whether to issue an early warning for the operation fault type, which can enhance accuracy of the early warning.

Based on this, as described above, an early warning indicator correlated with the operation fault type has been constructed, and a correspondence between the operation fault type and the early warning indicator can be further generated. By performing feature extraction on the operation data of the battery in the vehicle during operation, the operation data feature of the battery in the vehicle during operation can be obtained. When the operation data feature indicates that the battery exhibits the operation fault data feature correlated with the fault type during operation. Actual production data of the battery during production is obtained, and feature extraction is performed on the historical production data to obtain a historical production data feature. A target early warning indicator corresponding to an operation fault type is determined based on the correspondence between the operation fault type and the early warning indicator, to further verify whether to issue an early warning for the operation fault type. The historical production data feature is compared with the target early warning indicator. When the historical production data feature matches the target early warning indicator, it indicates that there is a high probability that the battery in the vehicle may be faulty, and early warning prompt information is issued. When the historical production data feature does not match the target early warning indicator, it indicates that a production process of a to-be-evaluated battery is normal, and no early warning is needed currently. It can be learned that early warning of the vehicle is performed by combining the historical production data feature and the operation data feature of the battery throughout an entire life cycle, which can enhance accuracy of the early warning for a vehicle fault.

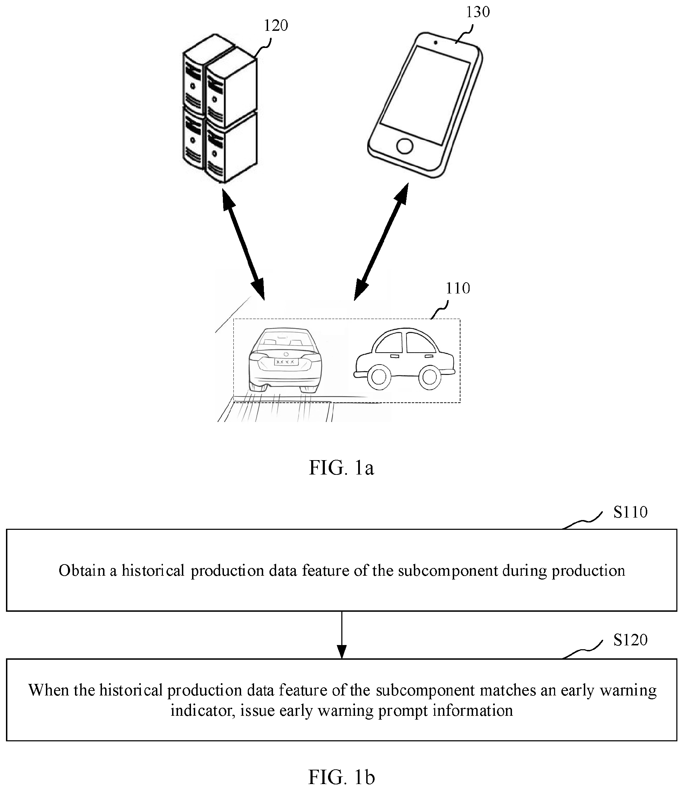

With reference to FIG. 1a, an early warning method for a vehicle provided in this scenario example can be used in a vehicle 110 in FIG. 1a, or used in other devices (for example, a cloud server 120, a mobile phone terminal 130, and the like in FIG. 1a) having a vehicle controlling function. The vehicle may be a self-driving vehicle. The self-driving vehicle may be a vehicle having a partial autonomous driving function, or may be a vehicle having a fully autonomous driving function. That is, based on classification criteria of the Society of Automotive Engineers (Society of Automotive Engineers, SAE), autonomous driving levels of the vehicle may be classified into no automation (L0), driving assistance (L1), partial automation (L2), conditional automation (L3), high automation (L4), and full automation (L5). The vehicle or other devices may implement the method for creating the early warning indicator by using components (including hardware and software) included in the vehicle or other devices. It should be understood that the vehicle may be a car, truck, motorcycle, bus, recreational vehicle, playground vehicle, construction device (such as an engineering vehicle), trolley, golf cart, train, handcart, or the like that uses a power battery. This is not specifically limited in implementations of this specification.

For example, an in-vehicle Tbox (Telematics box, an internet of vehicles system) sends initial operation data of a battery A during operation to the cloud server 120. The cloud server 120 can perform analysis and feature extraction on the received initial operation data, to obtain an operation fault data feature correlated with a fault type X. The cloud server 120 stores a historical production data feature F that describes deviation of actual production data of the battery from expected production data of the battery, and may further store a correspondence between an operation fault type and a production early warning indicator. The cloud server 120 performs matching in the correspondence between the operation fault type and the production early warning indicator based on the fault type X, to obtain a production early warning indicator Q correlated with the fault type X. When the historical production data feature F matches the early warning indicator Q, the cloud server 120 issues early warning prompt information to the vehicle.

The cloud server 120 may be an electronic device with a specific computational power. The cloud server 120 may include a network communication module, a processor, a memory, and the like. The server may be a distributed server, or may be a system with a plurality of processors, memories, network communications modules, and the like that operate collaboratively. Alternatively, the cloud server may be a server cluster formed by several servers. Alternatively, with the development of science and technology, the server may be a new technical means capable of implementing a corresponding function in implementations of this specification. For example, the server may be a new form of "server" implemented based on quantum computing.

An implementation of this specification provides an early warning method for a device. The device includes a subcomponent. With reference to FIG. 1b, the early warning method for the device may include the steps as follows.

S110: Obtain a historical production data feature of the subcomponent during production.

S120: When the historical production data feature of the subcomponent matches an early warning indicator, issue early warning prompt information.

The early warning indicator is created by: performing correlation analysis on sample production data and sample operation fault data of a preset subcomponent sample to obtain production fault correlation data, where there are a plurality of preset subcomponent samples; and when the production fault correlation data is greater than a predetermined threshold, determining an early warning indicator based on the sample production data corresponding to the sample operation fault data. The subcomponents may be different modules, components, or functional modules in a device, which together implement functions of the entire device or system. For example, a mainframe of a computer may be considered as a device, and the mainframe includes a plurality of subcomponents, such as a main board, a processor, a memory, a hard disk, and a video card. These subcomponents are responsible for different functions and work together to ensue normal operation of the entire computer system. The historical production data feature can characterize a deviation of historical production data of the subcomponent from expected production data during production process steps.

The early warning indicator may be a production indicator used to monitor whether there is an abnormal production situation correlated with a subcomponent operation fault during subcomponent production. The early warning indicator may directly use the target production data that meets an indicator screening condition, or the early warning indicator may use a target production data feature that is extracted based on the target production data and meets the indicator screening condition. The early warning indicator can be used as an important basis for process optimization, quality control, and fault early warning of an existing device.

The early warning prompt information may be used to remind or notify a possible abnormal production situation of the to-be-evaluated subcomponent during production. The early warning prompt information may include a unique identification code of the subcomponent, an actual production data feature of the subcomponent, and a fault type of the subcomponent. The early warning prompt information may be provided in the form of voice, or may be sent to an electronic device with a display function, such as at least one of a mobile terminal, an in-vehicle display unit, or a vehicle-mounted tablet computer.

Specifically, during subcomponent production, historical production data of the subcomponent during production is obtained. By performing feature extraction on the historical production data of the subcomponent during production, the historical production data feature of the subcomponents during production can be obtained. Then, matching is performed on the historical production data feature of the subcomponent and the early warning indicator. When the two match, it indicates that the production process of the subcomponents is abnormal, and the device issues early warning prompt information. If the two do not match, it indicates that the production process of the subcomponents is normal, no early warning is needed currently. In some implementations, the historical production data can be pre-stored locally in the device, and the historical production data can be obtained locally from the device. Alternatively, the historical production data can be pre-stored into another computer device (for example, a cloud server), and the historical production data can be obtained from the computer device. In yet other implementations, the historical production data feature of the subcomponent during production can be pre-stored locally in the device, and the historical production data feature of the subcomponent during production can be obtained locally from the device. Alternatively, the historical production data feature of the subcomponent during production can be pre-stored into another computer device (for example, a cloud server), and the historical production data feature of the subcomponent during production can be obtained from the computer device.

In the foregoing early warning method for the battery, the historical production data feature of the subcomponent during production is obtained. When the historical production data feature of the subcomponent matches the early warning indicator, the device subcomponent that actually has a potential fault risk but does not show any anomaly is determined, and then the early warning prompt information is issued. For the subcomponent that has been delivered from the factory and is in use, the early warning indicator can be used to analyze the subcomponent in use, to issue an accurate early warning for a subcomponent operation fault as early as possible. Further, an abnormal production situation of a subcomponent in production is prompted, to reduce delivery of an unqualified subcomponent, and enhance subcomponent safety. Alternatively, the early warning indicator can be used to optimize the process steps during subcomponent production to reduce a probability of a subcomponent fault.

It should be noted that the early warning indicator is created by: performing correlation analysis on the sample production data and the sample operation fault data of the preset subcomponent sample to obtain the production fault correlation data, where there are a plurality of preset subcomponent samples; and when the production fault correlation data is greater than the predetermined threshold, determining the early warning indicator based on the sample production data corresponding to the sample operation fault data. For example, the device is an electric energy device, the subcomponent is a battery, and the preset subcomponent sample is a preset sample battery.

There may be a plurality of preset subcomponent samples. Correlation analysis can be used to analyze two or more correlated variable elements to measure a degree of correlation between the two variable factors. Through correlation analysis, a relationship between different variable elements are mined. The sample production data may be raw data generated during production of any preset subcomponent sample, such as raw data generated during production of the preset sample battery or raw data generated during a chip production process. The sample production data may alternatively be a production data feature obtained by performing analysis or feature extraction on raw data generated during production of the preset subcomponent sample. The sample operation fault data may include a fault type and a data feature. The sample operation fault data may be operation data generated during operation of a faulty subcomponent sample, such as operation data of a faulty battery or operation data of a faulty chip. The operation fault data may alternatively be a sample operation fault data feature obtained by performing analysis or feature extraction on the operation fault data. Production fault correlation data is used to characterize a degree of correlation between production data and the fault type. For example, the production fault correlation data may be classified into complete correlation, uncorrelation, and incomplete correlation, or may be a value that may represent the magnitude of correlation, for example, the correlation is 20%, 50%, or 70%. The fault type may be understood as a type of an operation fault that occurs during operation of the faulty subcomponent sample, or may be an overall fault of the device caused by the faulty subcomponent sample. Taking the preset sample battery as an example, the fault type may be at least one of excessive self-discharge and internal short circuit. The fault type may alternatively be at least one of a vehicle engine startup difficulty or a vehicle electrical system fault.

In some cases, the correlation between the sample production data and the sample operation fault data is analyzed, so that the obtained production fault correlation data can better reflect true correlation between an operation fault of the preset subcomponent sample and a production anomaly exhibited during production of the preset subcomponent sample, thereby implementing mutual correlation of performance of the preset subcomponent sample throughout entire life cycles.

Specifically, before correlation analysis is performed, the sample production data and the sample operation fault data need to be obtained. The sample production data and the sample operation fault data can be pre-stored locally, and the sample production data and the sample operation fault data can be obtained locally. Alternatively, the sample production data and the sample operation fault data can be pre-stored into another computer device (for example, a cloud server), and the sample production data and the sample operation fault data can be obtained from the computer device. Alternatively, the sample production data may be pre-stored locally, the operation fault data can be collected, and the sample production data is obtained locally and the collected sample operation fault data is received.

It should be noted that the sample production data in the implementations of this specification may be obtained by using a data collection arrangement such as a sensor deployed in a preset subcomponent sample production line to collect data generated during production of the preset subcomponent sample. After the sample production data and the sample operation fault data are obtained, a correlation analysis algorithm is used to mine correlation between the obtained sample production data and the obtained sample operation fault data, to obtain the production fault correlation data. In yet other implementations, after the sample production data and the sample operation fault data are obtained, feature extraction can be performed on the sample production data to obtain a target production data feature. Feature extraction is performed on the sample operation fault data to obtain a sample operation fault data feature. A correlation analysis algorithm is used to mine the correlation between the target production data feature and the sample operation fault data feature to obtain production fault correlation data.

After the production fault correlation data is obtained based on the obtained sample production data and the obtained sample operation fault data, the production fault correlation data is compared with a predetermined threshold. When the production fault correlation data is greater than the predetermined threshold, it indicates that the production data corresponding to the production fault correlation data is highly correlated with an operation fault of the preset subcomponent sample. Therefore, the early warning indicator can be determined based on the sample production data corresponding to the production fault correlation data. For example, the sample production data corresponding to the production fault correlation data is analyzed, to obtain a target production data feature correlated with the fault type, and the target production data feature is used as an indicator to be created.

In yet other implementations, a plurality of target production data features corresponding to the production data can be pre-stored. When the production fault correlation data is greater than a predetermined threshold, the target production data feature correlated with the fault type can be directly used as an indicator to be created. In some implementations, as a number of produced preset subcomponent samples and a number of faulty subcomponent samples increase, the early warning indicator may be updated accordingly. For example, the existing early warning indicator may be modified, or a new early warning indicator may be added. Specifically, as the number of the produced preset subcomponent samples increases, a target production data feature stored in an abnormal feature database is updated. As the number of the faulty subcomponent samples increases, a sample operation fault data feature that is correlated with the fault type and stored in a sample fault trace database is updated. New production fault correlation data is obtained by performing correlation analysis on the updated target production data feature and the updated sample operation fault data feature. A new early warning indicator correlated with the fault type is determined from the updated target production data feature based on the new production fault correlation data.

In the foregoing indicator creating method, correlation analysis is performed on the obtained sample production data and sample operation fault data to obtain production fault correlation data; and when the production fault correlation data is greater than a predetermined threshold, an early warning indicator is determined based on the sample production data corresponding to the sample operation fault data. When some products are faulty, production data of the products can be analyzed based on the created indicator to accurately determine the product with a potential fault. Further, the created indicator may be further used to guide a production process of the products, thereby enhancing the quality of subsequent products.

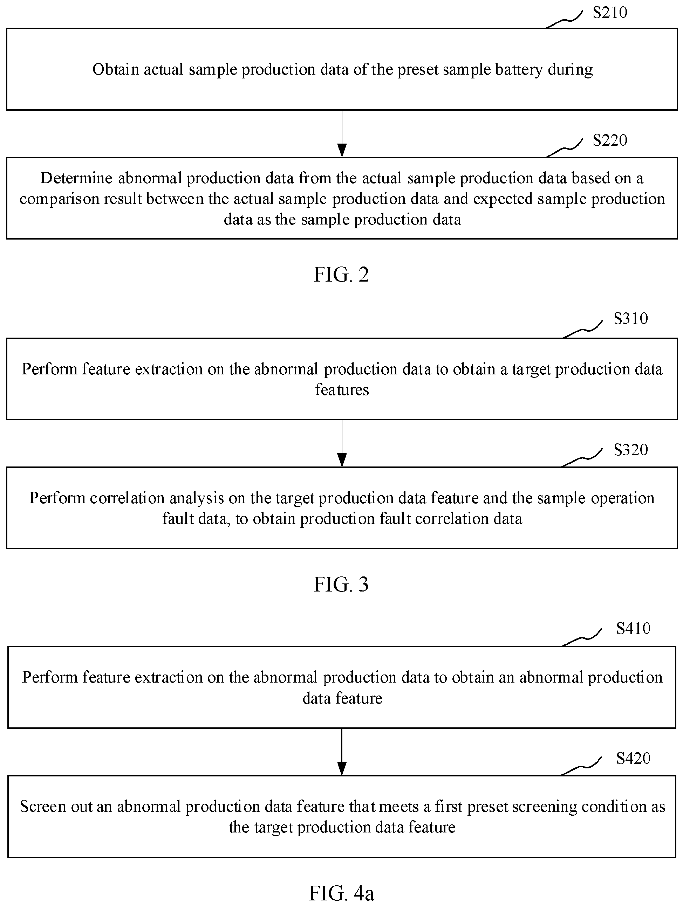

In some implementations, the device is an electric energy device, the subcomponent is a battery, and the preset subcomponent sample is a preset sample battery. With reference to FIG. 2, before performing correlation analysis on the sample production data and the sample operation fault data of the preset subcomponent sample, the method further includes the steps as follows.

S210: Obtain actual sample production data of the preset sample battery during production.

S220: Determine abnormal production data from the actual sample production data as the sample production data based on a comparison result between the actual sample production data and expected sample production data.

The actual sample production data may be data generated by the preset sample battery in the production process steps. The actual sample production data includes but is not limited to a front preset sample battery weight, a rear preset sample battery weight, an injection amount, a current*I_{HC}*, a voltage*V_{HC}*, a capacity*CAP_{HC},* and a temperature*T_{HC}* during formation, a current*I_{CD}*, a voltage *V_{CD}*, a capacity *CAP_{CD}* , and a temperature*T_{CD}* during charging, and a current*I_{FR}*, a voltage*V_{FR}*, a capacity*CAP_{FR}*, and a temperature*T_{FR}* during capacity grading. The actual sample production data corresponds to the expected sample production data. The expected sample production data may be expected production data considered during design of the preset sample battery, or may be production data that is compiled based on the sample production data of a large number of preset sample batteries and is more in line with actual production requirements after the preset sample batteries are put into production.

In some cases, the production process steps of the preset sample battery cannot maintain the actual sample production data of each preset sample battery at a constant ideal value. Moreover, the production process steps of the preset sample battery may cause an anomaly in the actual sample production data of the preset sample battery due to an inherent characteristic, a production environment, or other reasons.

Specifically, the actual sample production data of the preset sample battery during production can be obtained based on data generated in the process steps during production of the preset sample battery. The actual sample production data of the preset sample battery is compared with the expected sample production data of the preset sample battery to obtain a comparison result between the actual sample production data and the expected sample production data. Therefore, based on the comparison result between the actual sample production data and the expected sample production data, production data having an anomaly, that is, abnormal production data, can be determined from the actual sample production data of the preset sample battery, which is used as sample production data.

For example, preset sample batteries of different models have different expected sample production data. Therefore, a relational database of the preset sample batteries of various models and expected sample production data of the preset sample batteries of various models can be established. After the actual sample production data of the preset sample battery during production is obtained, search can be performed in the relational database based on a model of the preset sample battery. Searched expected sample production data of the preset sample battery is compared with the actual sample production data of the preset sample battery. Based on a comparison result, the abnormal production data can be determined from the actual sample production data, and used as the sample production data.

In this implementation, the obtained sample production data may be abnormal production data, and correlation analysis may be performed on the abnormal production data and the sample operation fault data, to obtain the production fault correlation data. The production fault correlation data can be used to characterize a degree of correlation between the abnormal production data and the fault types.

In the foregoing implementation, the actual sample production data of the preset sample battery during production is obtained. Then, based on the comparison result between the actual sample production data and the expected sample production data, the abnormal production data is determined from the actual sample production data. Finally, the abnormal production data is used as the sample production data. It can be learned that by comparing the actual sample production data with the expected sample production data, the abnormal production data may be determined and used as the sample production data, thereby narrowing a data range of correlation analysis, that is, a data mining range of the target production data feature can be reduced by determining the abnormal production data.

In some implementations, a method for determining the abnormal production data includes at least one of the following steps:
determining the actual sample production data different from the expected sample production data as the abnormal production data; or
determining the actual sample production data whose difference from the expected sample production data exceeds a preset difference threshold range as the abnormal production data.

The preset difference threshold range may be set based on actual situations, and different preset difference threshold ranges may be set based on preset sample batteries of different models. Because different process steps during production of the preset sample batteries may cause different degrees of error, the preset difference threshold range may be set based on error data that is allowed to exist in different production process steps during production of the preset sample batteries. For example: A battery capacity in the expected production data of the preset sample battery is generally set to 100%. In process steps during production of preset sample batteries, the preset sample batteries whose capacities range from 99.8% to 100% may be considered as preset sample batteries of a normal batch. Therefore, the preset difference threshold range of the preset sample battery capacity may be set to 0% to 0.2%.

Specifically, in some implementations, the actual sample production data can be compared with the expected sample production data. When there is a difference between the two, the actual sample production data with the difference can be determined as the abnormal production data. It can be understood that when the actual sample production data is the same as the expected sample production data, the corresponding actual sample production data is used as the normal production data.

In yet other implementations, the actual sample production data can be compared with the expected sample production data. When there is a difference between the two, the difference is further compared with the preset difference threshold range. Specifically, difference data between the actual sample production data and the expected sample production data is determined by comparing the actual sample production data and the expected sample production data, and the difference data is compared with the preset difference threshold range. When the difference data falls within the preset difference threshold range, the corresponding actual sample production data may be determined as the normal production data. When the difference data exceeds the preset difference threshold range, the corresponding actual sample production data may be determined as the abnormal production data.

In the foregoing implementations, the actual sample production data different from the expected sample production data is determined as the abnormal production data. Alternatively, the actual sample production data whose difference from the expected sample production data exceeds the preset difference threshold range is determined as the abnormal production data. Therefore, the abnormal production data can be determined through various methods. Furthermore, the preset difference threshold range is set, so that comparison flexibility between the actual sample production data and the expected sample production data is enhanced, and the abnormal production data can be more accurately determined.

In some implementations, with reference to FIG. 3, performing correlation analysis on the sample production data and the sample operation fault data of the preset subcomponent samples includes:
S310: Perform feature extraction on the abnormal production data to obtain a target production data feature.

Through feature extraction, a deviation of the abnormal production data from the expected production data can be obtained, and the deviation can be used as the target production data feature. The target production data feature is used to characterize a deviation of the actual production data of the battery from the expected production data of the battery. The target production data feature may be understood as an abnormal production data feature exhibited during battery production. For example: when a battery voltage is lower than expected voltage data, the target production data feature may be a voltage deviation value of the battery voltage from the expected voltage data. When a battery current is lower than expected current data, the target production data feature may be a current deviation value of the battery current from the expected current data. For another example, during charging in production of the battery, the voltage should show an upward trend in a normal case. When an actual production charging voltage of the battery shows a downward trend during charging in production, it indicates that there is a production anomaly. Therefore, the target production data feature may be that the battery voltage falls when there is a charging current during charging in production.

In some cases, an electrochemical process involved in the preset sample battery production process operates under relatively smooth and uniform conditions, with the preset sample battery in a quasi-steady state, and various parameters of the preset sample battery are determined in this stage. Therefore, the production process data of the preset sample battery can better reflect initial quality of the preset sample battery. An abnormal features exhibited in the production data of the preset sample battery may be a root cause of a fault of the preset sample battery during operation. Therefore, an abnormal target production data feature that exist during production of the preset sample battery needs to be determined.

To explore an association relationship between a battery operation fault and battery production data, it is necessary to first obtain the target production data feature during battery production and the operation fault data feature correlated with the fault type during operation of the faulty battery. Specifically, feature extraction is performed on the abnormal production data, so that a deviation of the abnormal production data from the expected production data of the battery can be obtained, and the target production data feature can be obtained based on the deviation of the abnormal production data from the expected production data of the battery.

For example, the actual production data having an anomaly can be obtained by comparing the actual production data during battery production with designed expected data. The target production data feature during battery production can be obtained by performing feature extraction on the actual production data having the anomaly.

S320: Perform correlation analysis on the target production data feature and the sample operation fault data to obtain production fault correlation data.

Correlation analysis can be used to analyze two or more correlated variable elements to measure a degree of correlation between the two variable factors. Through correlation analysis, a relationship between different variable elements are mined. Production fault correlation data is used to characterize a degree of correlation between target production data feature and the fault types. For example, the production fault correlation data may be classified into complete correlation, uncorrelation, and incomplete correlation.

In some cases, correlation analysis is performed on the target production data feature and the operation fault data feature, so that the obtained production fault correlation data can better reflect true correlation between the battery operation fault and the production anomaly exhibited during battery production, thereby implementing mutual correlation of performance of the battery throughout an entire life cycle.

Specifically, a correlation analysis algorithm is used to mine correlation between the target production data feature and the sample operation fault data, so that the production fault correlation data between the target production data feature and the fault type can be obtained, to quantify a degree of correlation between the target production data feature and the fault type.

In the foregoing implementation, the target production data feature is determined, and correlation analysis is performed on the target production data feature and the sample operation fault data, so that a data mining range of the target production data feature correlated with the fault type can be reduced, thereby enhancing a data processing speed.

In some implementations, with reference to FIG. 4a, after performing feature extraction on the abnormal production data, the method further includes the following steps.

S410: Perform feature extraction on the abnormal production data to obtain an abnormal production data feature.

Specifically, the abnormal production data of the preset sample battery during production can be obtained based on data generated in process steps during production of the preset sample battery. By performing feature extraction on the abnormal production data, a production situation corresponding to the abnormal production data can be obtained, and the abnormal production data feature can be obtained based on the production situation corresponding to the abnormal production data. Feature extraction methods include but are not limited to derivation, a threshold range, and the like.

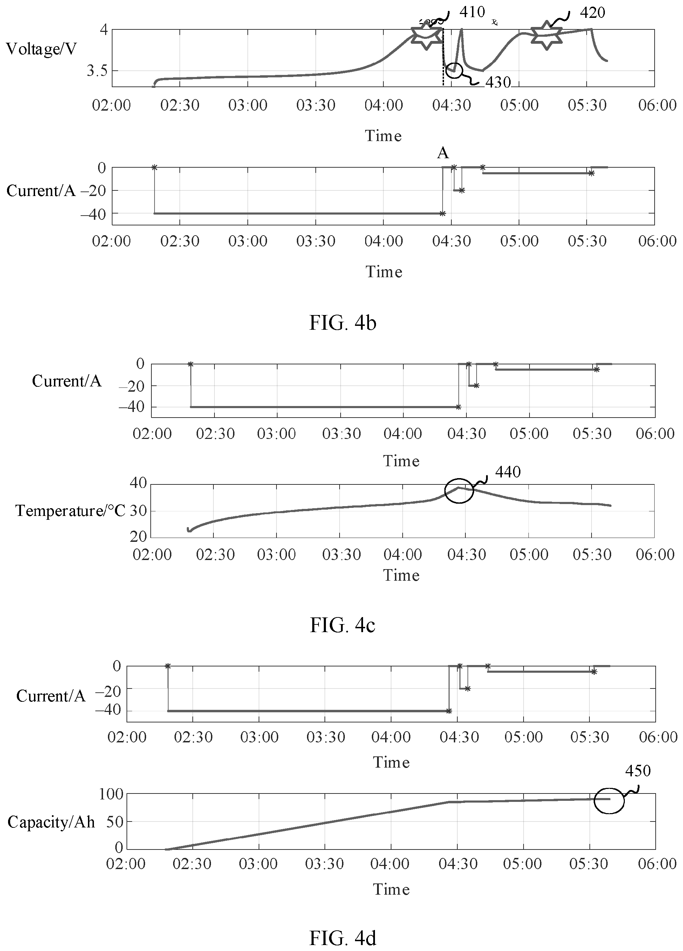

For example, during charging in production of the preset sample battery, a voltage of the preset sample battery needs to always show an upward trend under a normal charging condition. With reference to FIG. 4b, by performing derivation on a voltage curve of a charging part in FIG. 4b, a position where a zero point exists in the curve can be obtained. If the zero point exists, it may be considered that the voltage first raises and then falls or the voltage first falls and the raises during charging of the preset sample battery, and then it is considered that the preset sample battery is abnormal. Both 410 and 420 in FIG. 4b have positions where the zero point exists. The abnormal production data feature of the preset sample battery may be represented as that the voltage of the preset sample battery falls when there is a charging current during charging in production. Then, a data feature 410 and a data feature 420 belong to a classified abnormal data feature M. It should be noted that if a current is negative, it indicates that the preset sample battery is being charged. At 430 in FIG. 4b, charging of the preset sample battery has been stopped, and the voltage falls because the voltage of the preset sample battery falls back after a charging power supply is disconnected. The voltage of the preset sample battery that falls back within a specified range after charging stops is reasonable and normal.

For example, a voltage difference within a specific range is reasonable. Therefore, a preset threshold range is set for the voltage difference. With reference to FIG. 4b, a difference between a voltage at 04:30 in FIG. 4b and a voltage at A in FIG. 4b is calculated. When the value exceeds the preset threshold range, it is considered that the preset sample battery is abnormal. The abnormal production data feature of the preset sample battery may be represented as that the voltage difference exceeds the preset threshold range.

For example, during charging of the preset sample battery, a temperature of the preset sample battery may fluctuate within a specific range. Therefore, a preset threshold range is set for the temperature of the preset sample battery. With reference to FIG. 4c, during charging of the preset sample battery, when a temperature at a position 440 in FIG. 4c exceeds the preset threshold range, it is considered that the preset sample battery is abnormal. The abnormal production data feature of the preset sample battery may be represented as that the battery temperature is too high when there is a charging current during charging in production.

For example, the preset sample battery capacity within a specific range is reasonable. Therefore, a preset threshold range is set for the preset sample battery capacity. With reference to FIG. 4d, during charging of the preset sample battery, when the preset sample battery capacity stops increasing after reaching a position 450 in FIG. 4d, and the value is not within the preset threshold range, it is considered that the preset sample battery is abnormal. The abnormal production data feature of the preset sample battery may be represented as that the preset sample battery capacity does not reach a calibrated battery capacity.

S420: Screen out the abnormal production data feature that meets a first preset screening condition as the target production data feature.

The first preset screening condition may be true correlation and credibility between the abnormal production data feature and the battery fault.

In some cases, not all abnormal production data features can be stored into the abnormal feature database. Therefore, the first preset screening condition is used as an entry condition of the abnormal feature database, to ensure the true correlation and credibility of the abnormal production data feature stored in the abnormal feature database as much as possible. If data enters the database arbitrarily without based on the first preset screening condition, a risk such as a false early warning may occur.

Specifically, by analyzing the abnormal production data feature, it can be determined whether the abnormal production data feature meets the first preset screening condition, the production data feature that meets the first preset screening condition is used as a target production data feature, and the target production data feature is stored into the abnormal feature database.

In yet other implementations, the abnormal production data feature corresponds to a second cause. The second cause is a fault reason that causes the abnormal production data feature. The second cause may be a reason that can lead to the exhibition of the abnormal production data feature and that is obtained manually based on related knowledge and experience.

In some cases, not all abnormal production data features can be stored into the abnormal feature database, but the second cause is used as the entry condition of the abnormal feature database, to ensure true correlation and credibility of the abnormal production data feature stored in the abnormal feature database as much as possible. If data enters the database arbitrarily without based on the second cause, a risk such as a false early warning may occur. Specifically, by performing cause analysis on the abnormal production data feature, a reason for generating the abnormal production data feature, that is, the second cause, can be determined. In actual applications, correlation between the second cause and the abnormal production data feature is verified to determine whether the second cause is a true reason for generating the abnormal production data feature. When the second cause is the true reason, it may be considered that the second cause meets the first preset screening condition, and the abnormal production data feature can be stored into the abnormal feature database.

For example, continuing to refer to FIG. 4b, the abnormal production data feature of the preset sample battery is represented as that the voltage of the preset sample battery falls when there is a charging current during charging in production. Cause analysis is performed on the abnormal production data feature of the preset sample battery. It may be considered that a reason for generating the abnormal production data feature of the preset sample battery is as follows: during production of the preset sample battery, dust adheres to an electrode sheet or leakage causes a slight internal short circuit inside the preset sample battery, resulting in a decrease in internal resistance. Verification is performed on true correlation and accuracy between the decrease of the internal resistance caused by the slight internal short circuit inside the preset sample battery when dust adheres to the electrode sheet or leakage occurs during battery production, and the fall of the voltage of the preset sample battery when there is a charging current during charging in production. When there is a true and credible association relationship between the two, it may be considered that the second cause meets the first preset screening condition, and a production data feature that the voltage of the preset sample battery falls when there is a charging current during charging in production may be used as the target production data feature that needs to be stored into the abnormal feature database.

For example, the abnormal production data feature of the preset sample battery is represented as that the temperature of the preset sample battery is too high when there is a charging current during charging in production. Cause analysis is performed on the production data feature of the preset sample battery. It may be considered that a reason for generating the abnormal production data feature of the preset sample battery is as follows: the preset sample battery itself has a problem with a transmission characteristic, resulting in an internal circuit anomaly. Verification is performed on true correlation and accuracy between the internal circuit anomaly caused by the situation that the preset sample battery itself has a problem with the transmission characteristic and the excessive high temperature of the preset sample battery when there is a charging current during charging in production. When there is a true and credible association relationship between the two, it may be considered that the second cause meets the first preset screening condition, and a production data feature that the battery temperature is too high when there is a charging current during charging in production can be used as the target production data feature that needs to be stored into the abnormal feature database.

In the foregoing implementation, the abnormal feature database is constructed, and the abnormal production data feature that meets the first preset screening condition is stored into the abnormal feature database, so that the true correlation and credibility between the abnormal production data feature stored in the abnormal feature database and the battery fault can be ensured as much as possible. In addition, the abnormal production data feature of the preset sample battery can be accumulated, providing a data source for optimizing the preset sample battery production process or technology.

In some implementations, before performing correlation analysis on the sample production data and the sample operation fault data of the preset subcomponent sample, the method may further include: obtaining a sample operation fault data feature from the sample fault trace database as the sample operation fault data.

The sample operation fault data feature is used to characterize a situation where an anomaly exists in actual operation data of the preset sample battery. For example, during charging, compared with other preset sample batteries of the same model, the preset sample battery experiences a rapid voltage rise, and a terminal voltage of the preset sample battery reaches a cutoff voltage earlier. Therefore, the sample operation fault data feature may be that the preset sample battery experiences a rapid voltage rise and the terminal voltage of the same reaches the cutoff voltage earlier than that of normal preset sample battery.

In some cases, when the preset sample batteries are put into use, different battery faults occur based on the use of different vehicle batteries. Therefore, the sample operation fault data feature needs to be used to describe anomaly data that exists during operation of the battery in use.

Specifically, a sample fault trace database is provided in advance, and a plurality of sample operation fault data features are stored into the sample fault trace database. The sample operation fault data feature may be obtained from the sample fault trace database and used as the sample operation fault data.

In the foregoing implementation, by obtaining the sample operation fault data feature from the sample fault trace database, correlation analysis can be performed on the sample operation fault data feature and the target production data, thereby reducing a data mining range of the target production data feature correlated with the fault type, and enhancing a data processing speed.

In some implementations, a method for constructing the sample fault trace database includes: obtaining an operation data feature of a faulty battery during operation; screening out the operation data feature that meets a second preset screening condition as a sample operation fault data feature; and storing the sample operation fault data feature into the sample fault trace database.

The faulty battery is the preset sample battery on which a fault occurs during operation. The second preset screening condition may be true correlation and credibility between the operation data feature and the battery fault.

In some cases, not all operation data features can be stored into the fault trace database. Therefore, the second preset screening condition is used as an entry condition of the sample fault trace database, to ensure true correlation and reliability of the operation data feature stored in the sample fault trace database as much as possible. If data enters the database arbitrarily without based on the second preset screening condition, a risk such as a false early warning may occur.

Specifically, by analyzing the operation data feature, it can be determined whether the operation data feature meets the second preset screening condition. The operation data feature that meets the second preset screening condition are used as the sample operation fault data feature, and the sample operation fault data feature is stored into the sample fault trace database.

In yet other implementations, the operation data feature corresponds to a first cause. The first cause is a fault leading to the generation of the operation data feature, and the first cause may be a reason that is obtained manually based on related knowledge and experience and that can lead to the generation of the operation data feature.

In some cases, not all operation data features can be stored into the fault trace database, but the first cause is used as an entry condition of the sample fault trace database, to ensure true correlation and reliability between the operation data feature stored in the sample fault trace database and the battery fault. If data enters the database arbitrarily without based on the first cause, a risk such as a false early warning may occur.

Specifically, by performing cause analysis on the operation data feature, a reason for generating the operation data feature, that is, the first cause, can be determined. In actual applications, correlation between the first cause and the operation data feature is verified to determine whether the first cause is a true reason for generating the operation data feature. If the first generation cause is the true reason, it may be considered that the first cause meets a fault feature screening condition, and the operation data feature can be stored into the sample fault trace database.

For example, the operation data feature of the preset sample battery indicates that the battery voltage rises too rapid and reaches the cut-off voltage first during charging. Cause analysis is performed on the operation data feature of the preset sample battery. It may be considered that a reason why the preset sample battery generates the operation data feature is as follows: compared with other preset sample battery cells, the preset sample battery has a relatively small internal resistance. Verification is performed on true correlation and accuracy between the relatively small internal resistance of the preset sample battery and the situation that the voltage of the preset sample battery rises too rapid and reaches the cut-off voltage first during charging. When there is a true and credible correlation between the two, it may be considered that the first cause meets the fault feature screening condition. The operation data feature that the voltage of the preset sample battery rises too fast and reaches the cut-off voltage first during charging may be used as the sample operation fault data feature of the sample that needs to be stored into the sample fault trace database.

In the foregoing implementation, by constructing the sample fault trace database, the operation data feature that meets the second preset screening condition is stored into the sample fault trace database, so that the true correlation and credibility between the operation data feature stored in the sample fault trace database and the battery fault can be ensured as much as possible. In addition, the operation data feature of the faulty battery can be accumulated, providing an accurate data source for battery fault analysis.

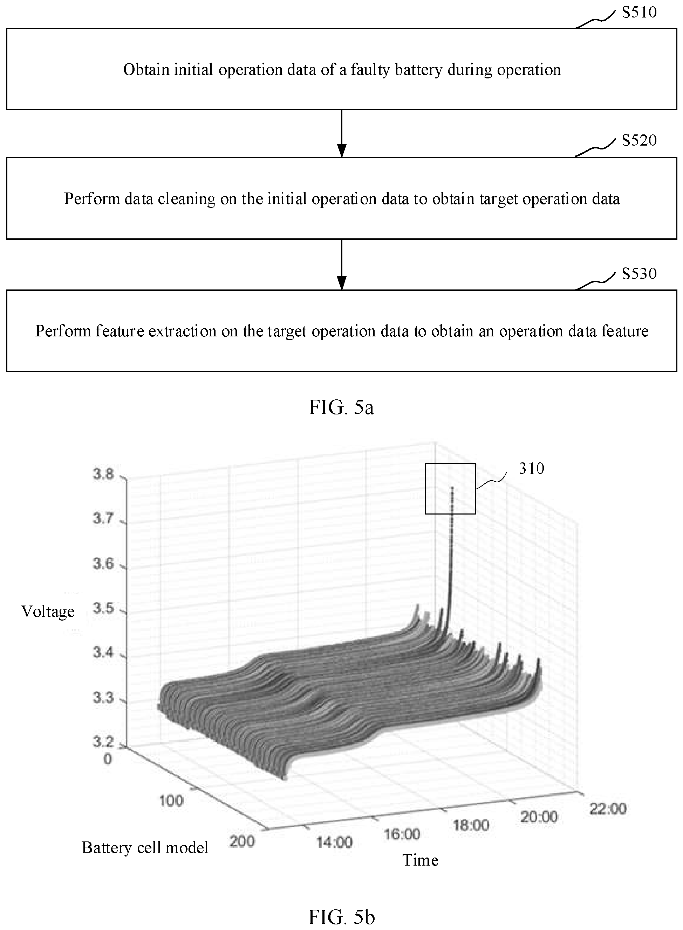

In some implementations, with reference to FIG. 5a, obtaining the operation data feature of the faulty battery during operation may include the steps as follows.

S510: Obtain initial operation data of the faulty battery during operation.

S520: Perform data cleaning on the initial operation data to obtain target operation data.

The initial operation data may include but is not limited to a current*I_{Cell}*, a voltage*V_{Cell},* a capacity*CAP_{Cell}*, a battery state of charge*SOC*, and a temperature*T_{Cell}* of a battery cell.

In some cases, the initial operation data of the faulty battery during operation may include some interference data and incomplete data. Therefore, impact of noise or inaccurate data on extraction of the operation data feature is reduced by means of data cleaning, enhancing accuracy of the operation data feature.

Specifically, the vehicle to which the faulty battery belong sends the initial operation data of the faulty battery during operation to a cloud server via the in-vehicle Tbox, and the cloud server receives the initial operation data. Then, the cloud server performs data cleaning on the initial operation data, to obtain the target operation data.

S530: Perform feature extraction on the target operation data to obtain the operation data feature.

The operation data feature is used to characterize a situation that an anomaly exists in the target operation data of the faulty battery during operation.

Specifically, by performing feature extraction on the target operation data, an abnormal operation situation of the target operation data during operation of the faulty battery can be obtained, and the operation data feature correlated with the operation process can be obtained based on the abnormal operation situation. Feature extraction methods include but are not limited to derivation, a threshold range, and the like.

For example, FIG. 5b is a diagram of battery cell voltages of a vehicle that is sent by an in-vehicle Tbox after data cleaning. In FIG. 5b, there is an operation data feature 310 that a voltage rise speed of a battery is higher than those of other batteries in a same period and a charging terminal voltage of the battery reaches the cut-off voltage first. The operation data feature 310 belongs to a classified fault data feature Y. The voltage of the battery may be compared with those of batteries of the same model, and a position of the battery having a voltage anomaly and the performance of the voltage anomaly can be extracted based on a threshold range of the battery voltage. Then, the operation data feature of the battery may be represented as that the battery voltage rises too fast and reaches the cut-off voltage first during charging.

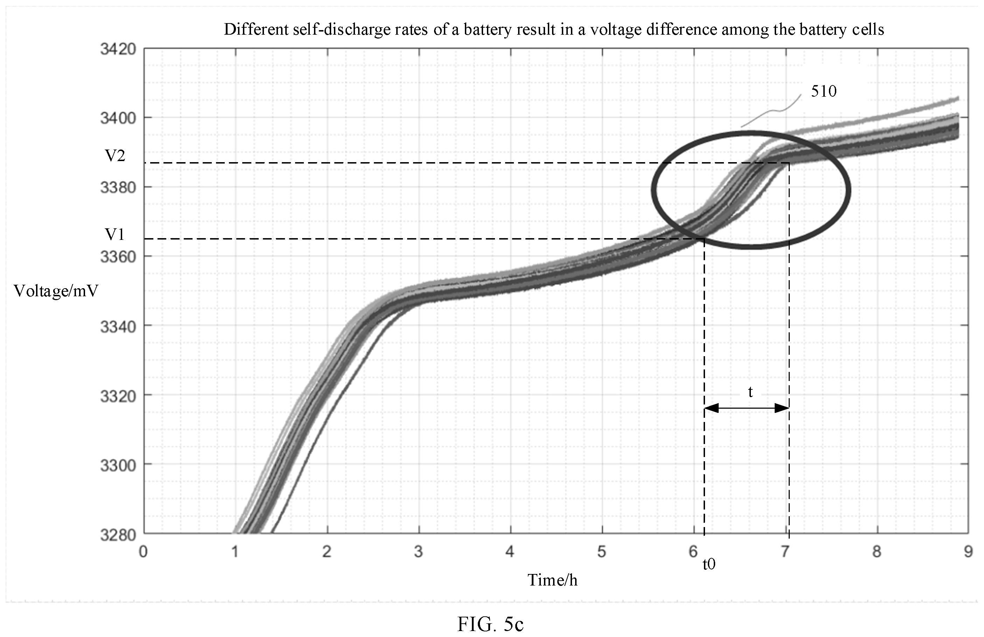

For example, different battery discharge rates may result in voltage differences among battery cells. During battery discharging, the battery releases stored charges to supply a current load. At different discharge rates, a rate of mechanical reactions and a rate of energy release within the battery may also vary. FIG. 5c is a diagram of battery cell voltages of a vehicle. Based on a formula: self-discharge rate = ((V1-V2)/(t-t0))*100%, different self-discharge rates of different battery cells in FIG. 5c can be obtained, and in FIG. 5c, there is an operation data feature 510 that a self-discharge rate of a battery cell is significantly different from those of other battery cells. The operation data feature 510 belongs to a classified fault data feature Z. Different battery self-discharge rates result in voltage differences among battery cells in a vehicle battery pack. Accumulation of the voltage differences may lead to a malfunction such as limited SOC for discharge of the battery pack. Then, the operation data feature of the battery may be represented as that different battery self-discharge rates may result in voltage differences among the battery cells in the vehicle battery pack. V1 is a battery voltage at an initial moment. V2 is a battery voltage after a period of time t. t0 is the initial moment, that is, a time before self-discharge measurement starts. t is an elapsed time.

In the foregoing implementation, the target operation data is obtained by obtaining the initial operation data of the faulty battery during operation, and performing data cleaning on the initial operation data. Through data cleaning, impact of noise or inaccurate data on the extraction of the operation data feature is reduced, thereby enhancing accuracy of the operation data feature.

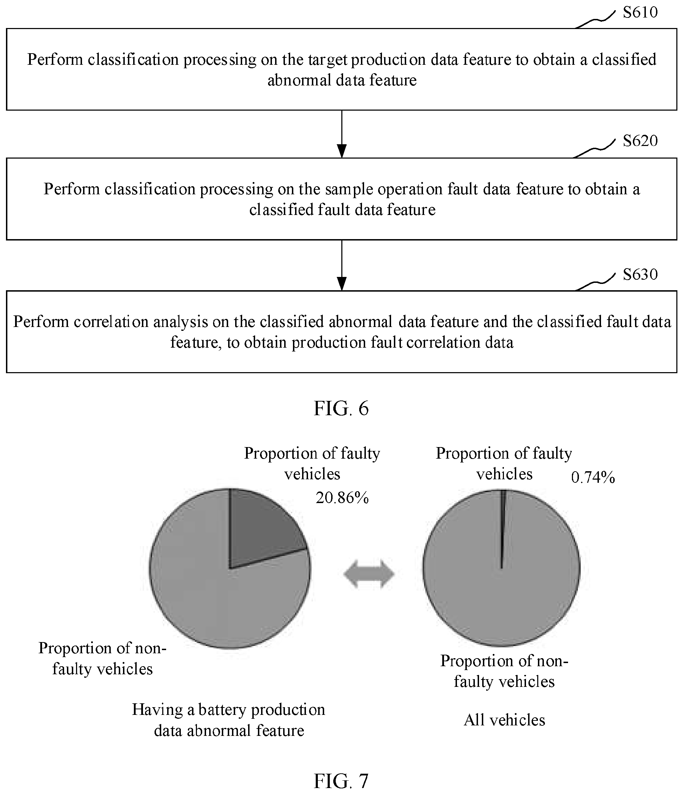

In some implementations, with reference to FIG. 6, after obtaining the target production data feature, the method further may include the step as follows.

S610: Perform classification processing on the target production data feature to obtain a classified abnormal data feature.

After the obtaining the sample operation fault data feature, the method includes the steps as follows.

S620: Perform classification processing on the sample operation fault data feature to obtain a classified fault data feature.

S630: Perform correlation analysis on the classified abnormal data feature and the classified fault data feature to obtain production fault correlation data.

In some case, by separately classifying the target production data feature and the sample operation fault data feature, and performing correlation analysis on the features obtained by classification, instead of randomly and aimlessly mining correlation between the target production data feature and the sample operation fault data feature, specific analysis can be performed in a targeted manner, thereby enhancing accuracy and credibility of a correlation analysis result to a certain extent.

Specifically, by performing classification processing on the target production data feature, the classified abnormal data feature can be obtained. By performing classification processing on the sample operation fault data feature, the classified fault data feature can be obtained. By performing correlation analysis on the classified abnormal data feature and the classified fault data feature to mine correlation between the classified abnormal data feature and the classified fault data feature, the production fault correlation data describing a degree of correlation between the target production data feature and the fault type can be obtained.

In the foregoing implementation, correlation analysis is performed on the classified abnormal data feature and the classified fault data feature, so that the obtained correlation data can better reflect true correlation between the battery operation fault and the production anomaly exhibited during battery production, thereby implementing mutual correlation of performance of the battery throughout an entire life cycle.

In some implementations, an analysis method for performing correlation analysis to obtain the production fault correlation data includes at least one of clustering, variance analysis, and proportion statistics.

Specifically, at least one of clustering, variance analysis, and proportion statistics can be used to perform correlation analysis on the obtained production data and operation fault data, and production fault correlation data describing a degree of correlation between the target production data feature and the fault type can be obtained based on a correlation analysis result.

In this implementation, the obtained production data may be understood as the classified abnormal data feature, and the operation fault data may be understood as the classified fault data feature. Therefore, at least one of clustering, variance analysis, and proportion statistics can be used to perform correlation analysis on the classified abnormal data feature and the classified fault data feature, to obtain production fault correlation data. At least one of clustering, variance analysis, and proportion statistics can be used to perform correlation analysis on the classified abnormal data feature and the classified fault data feature, and production fault correlation data describing the degree of correlation between the target production data feature and the fault type can be obtained based on a correlation analysis result.

For example, proportion statistics is used to perform correlation analysis on the classified abnormal data feature and the classified fault data feature, to obtain the production fault correlation data. With reference to FIG. 7, for example, a number of the preset battery samples is 10,000, corresponding vehicles in which the preset battery samples are installed are sample vehicles, and a battery with a classified abnormal data feature M among the preset battery samples is a target battery. Among the 10,000 sample vehicles, a percentage of faulty vehicles with a classified fault data feature Y is 0.734%. Among vehicles installed with the target batteries, a proportion of the faulty vehicles with the classified fault data feature Y is 20.86%. If a proportion of the faulty vehicles among the vehicles with the battery production data abnormal feature (20.86%) is significantly higher than a proportion of the faulty vehicles among the entire vehicles (0.734%), it can be considered that the production data abnormal feature is significantly correlated with the vehicle battery fault. For the proportion data of the two, whether there is a significant difference between the proportion data of the two can be confirmed based on a magnitude difference therebetween.

For example, in general, clustering analysis may classify significantly correlated elements into a same cluster. Clustering analysis is performed on the classified abnormal data feature and the classified fault data feature. When a classified abnormal data feature A and a classified fault data feature B are classified into a same cluster C through clustering analysis, it can be considered that there is a potential correlation between the classified abnormal data feature A and the classified fault data feature B. Further analysis is needed to obtain corresponding production fault correlation data.

For example, the classified abnormal data feature and the classified fault data feature are used as independent variables, and the fault type is used as a dependent variable. Intra-group variation can be obtained based on the classified abnormal data feature and the classified fault data feature. The inter-group variation can be obtained through the independent variable, that is the classified abnormal data feature and the classified fault data feature, and the dependent variable, that is, the fault type. Analyzing significant impact of the intra-group variation and inter-group variation can determine data that plays a decisive role.

In the foregoing method for creating the early warning indicator, at least one of clustering, variance analysis, and proportion statistics is used to perform correlation analysis to obtain the production fault correlation data. The production fault correlation data can better reflect true correlation between the battery operation fault and the production anomaly exhibited during battery production, thereby implementing mutual correlation of performance of the battery throughout an entire life cycle.

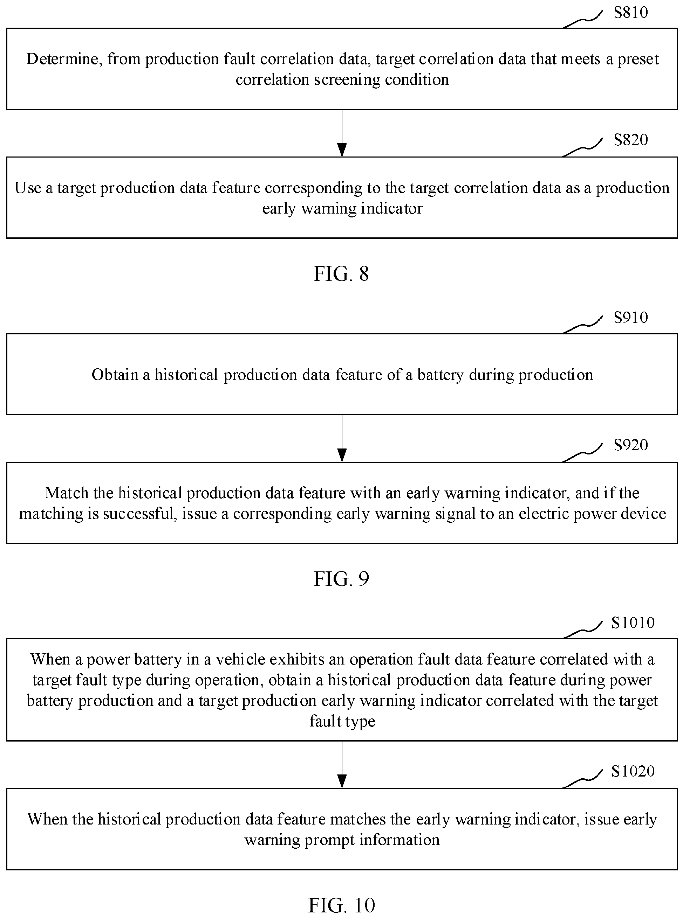

For example, with reference to FIG. 8, determining the production early warning indicator may include the steps as follows.

S810: Determine, from the production fault correlation data, target correlation data that meets a preset correlation screening condition.

S820: Use a target production data feature corresponding to the target correlation data as a production early warning indicator.

There are various degrees of correlation between the target production data feature and the fault type included in the production fault correlation data. Therefore, the preset correlation screening condition is set to evaluate the correlation between the target production data feature and the fault type, and screen out the target correlation data based on the target production data feature whose correlation with the fault type reaches an expectation.

Specifically, screening is performed on the production fault correlation data based on the preset correlation screening condition, to obtain the target correlation data that meets the preset correlation screening condition. The target production data feature corresponding to the target correlation data is then used as the production early warning indicator.

In the foregoing implementation, the target correlation data that meets the preset correlation screening condition is determined, and the corresponding target production data feature is used as the production early warning indicator. By using the preset correlation screening condition, it is ensured as much as possible that the abnormal production data feature correlated with the battery fault is used as the production early warning indicator, enhancing accuracy of the production early warning indicator.

An implementation of this specification provides an early warning method, applied to a network device, for an electric energy device. The electric energy device includes a battery. With reference to FIG. 9, the early warning method for an electric energy device may include the steps as follows.

S910: Obtain a historical production data feature of the battery during production.

An early warning indicator is obtained according to the method for creating an early warning indicator in any one of the foregoing implementations. The historical production data feature characterizes a deviation of historical production data of the battery from expected production data in production process steps.

Specifically, by performing feature extraction on operation data of the battery in the electric energy device during operation, an operation data feature of the battery in the electric energy device during operation can be obtained. When the operation data feature indicates that the battery exhibits the operation fault data feature correlated with the fault type during operation. In some implementations, the historical production data feature of the battery during production can be pre-stored into a storage unit of the electric energy device, and the historical production data feature of the battery during production can be directly obtained from the storage unit. In still other implementations, actual production data of the battery during production is obtained, and feature extraction is performed on the actual production data to obtain the historical production data feature.

S920: Match the historical production data feature with an early warning indicator, and if the matching is successful, issue a corresponding early warning signal to the electric energy device, so that the electric energy device issues early warning prompt information based on the early warning signal.

A method for creating the early warning indicator includes: performing correlation analysis on sample production data and sample operation fault data of preset sample battery to obtain production fault correlation data, where there are a plurality of preset sample batteries. When the production fault correlation data is greater than a predetermined threshold, the early warning indicator is determined based on the sample production data corresponding to the sample operation fault data.

Specifically, after the historical production data feature is obtained, the early warning indicator correlated with the fault type can be obtained from the storage unit of the electric energy device, or the early warning indicator correlated with the fault type can be obtained from the cloud server. Further, matching is performed on the obtained historical production data feature and the early warning indicator correlated with the fault type. If the two match, it indicates that a production process of the battery in the electric energy device is abnormal, and the corresponding early warning signal is issued to the electric energy device, so that the electric energy device issues the early warning prompt information based on the early warning signal. If the two do not match, it indicates that the production process of the battery in the electric energy device is normal, and no early warning is needed currently.

It should be noted that in this implementation, there may be one or a plurality of electric energy devices. When there are a plurality of electric energy devices, batch early warning can be performed on the plurality of electric energy devices, so as to implement batch early warning with relatively high accuracy. In the foregoing early warning method for an electric energy device, the historical production data feature of the battery during production is obtained. When the historical production data feature matches the early warning indicator correlated with the fault type, the early warning prompt information is issued. An early warning is performed based on data throughout the entire life cycle, enhancing improving accuracy of the early warning for the battery in the electric energy device.

An implementation of this specification provides an early warning method applied to an electric device. The electric device includes a battery. The method may include: receiving an early warning signal sent by a network device, and issuing corresponding early warning prompt information based on the early warning signal, where the early warning signal is determined by the network device based on a matching status between a historical production data feature of the battery and an early warning indicator.

A method for creating the early warning indicator includes: performing correlation analysis on sample production data and sample operation fault data of a preset sample battery to obtain production fault correlation data, where there are a plurality of preset sample batteries; and when the production fault correlation data is greater than a predetermined threshold, determining the early warning indicator based on the sample production data corresponding to the sample operation fault data.

The electric device side may be any one of various devices installed with batteries, such as a vehicle, a drone, a ship, an aircraft, a temperature regulator, a computer, or a mobile phone. Specifically, the network device determines the historical production data feature of the battery, matches the historical production data feature of the battery with a production early warning indicator, and the network device determines the early warning signal based on the matching status. The network device issues the early warning signal to the electric device. The electric device receives the early warning signal sent by the network device, and then issues the corresponding early warning prompt information based on the early warning signal.

In the foregoing early warning method, the early warning signal is issued to the electric device based on the matching status between the historical production data feature of the battery and the production early warning indicator, and then the corresponding early warning prompt information is issued based on the early warning signal. The early warning is performed based on the data throughout the entire life cycle, thereby improving accuracy of early warning for the electric device.

An implementation of this specification provides an early warning method applied to an electric device. The electric device includes a battery. The electric device stores a historical production data feature of the battery. The method includes: receiving an early warning indicator sent by a network device; and matching the historical production data feature with the early warning indicator, and if the two match, issuing corresponding early warning prompt information.

A method for creating the early warning indicator includes: performing correlation analysis on sample production data and sample operation fault data of a preset sample battery to obtain production fault correlation data, where there are a plurality of preset sample batteries; and when the production fault correlation data is greater than a predetermined threshold, determining the early warning indicator based on the sample production data corresponding to the sample operation fault data.

The electric device side may be any one of various devices installed with batteries, such as a vehicle, a drone, a ship, an aircraft, a temperature regulator, a computer, or a mobile phone. Specifically, the network device sends a production early warning indicator to the electric device. The electric device receives the early warning indicator sent by the network device. Matching is performed on the historical production data feature of the battery stored locally and the production early warning indicator, and if the two match, corresponding early warning prompt information is issued.

In the foregoing early warning method, the production early warning indicator is received, and the corresponding early warning prompt information is issued based on the matching status between the historical production data feature and the production early warning indicator. An early warning is performed based on the data throughout the entire life cycle, thereby improving accuracy of the early warning for the electric device.

An implementation of this specification provides a network device, including a memory and a processor. The memory stores a computer program. When the processor executes the computer program, the method according to any one of the foregoing implementations is implemented.

An implementation of this specification provides an electric energy device, including a memory and a processor. The memory stores a computer program. When the processor executes the computer program, the method according to any one of the foregoing implementations is implemented.

In some implementations, the electric energy device is a vehicle, a ship, or an aircraft.

An implementation of this specification provides a computer-readable storage medium. When instructions in the computer-readable storage medium are executed by a processor of an electronic device, the electronic device is enabled to perform the method according to any one of the foregoing implementations.

An implementation of this specification provides a computer program product, including a computer program. When the computer program is executed by the processor, the method according to any one of the foregoing implementations is implemented.

An implementation of this specification provides an early warning method for a vehicle. With reference to FIG. 10 the method may include the steps as follows.

S1010: When a power battery in a vehicle exhibits an operation fault data feature correlated with a target fault type during operation, obtain a historical production data feature during power battery production and a target production early warning indicator correlated with the target fault type.

In some cases, relying solely on operation data generated by the power battery during operation for early warning may ignore that abnormal feature exhibited in production data of the battery could be a root reason of battery faults during operation. Therefore, in this implementation, the operation data generated by the power battery during operation and the production data generated by the battery during production are combined, so that from the perspective of the entire life cycle, an early warning for the vehicle is performed by combining the operation data and the production data throughout the entire life cycle.

Specifically, the operation fault data feature correlated with the target fault type may be set in advance. By performing feature extraction on the operation data of the power battery in the vehicle during operation, an operation data feature of the power battery in the vehicle during operation can be obtained. When the operation data feature indicates that the power battery exhibits the operation fault data feature correlated with the target fault type during operation, to perform early warning for the vehicle from the perspective of the entire life cycle, the historical production data feature of the power battery during formation and the target production early warning indicator correlated with the target fault type can be further obtained.

In this implementation, the production early warning indicator can be stored into a storage unit of the vehicle, and the production early warning indicator can be directly obtained from the storage unit of the vehicle. The early warning indicator is obtained according to the method for creating an early warning indicator in any one of the foregoing implementations.

In this implementation, the historical production data feature can be stored in the storage unit of the vehicle, and the historical production data feature can be directly obtained from the storage unit of the vehicle. Alternatively, historical production data of the power battery can be stored in the storage unit of the vehicle, and the historical production data of the power battery can be obtained from the storage unit of the vehicle. Feature extraction is performed on the historical production data of the power battery to obtain the historical production data feature.

In some cases, in consideration of a computational power and storage space of the vehicle, the operation fault data feature is determined at the vehicle based on the operation data of the power battery during operation. The historical production data can be stored into a server A. A server B obtains the historical production data of the power battery from the server A. The server B performs feature extraction on the historical production data of the power battery, to obtain the historical production data feature. The server B may further store the production early warning indicator. The server B determines the target production early warning indicator correlated with the target fault type. The server B sends the historical production data feature and the target production early warning indicator that is correlated with the target fault type to the vehicle. The vehicle obtains the historical production data feature and the target production early warning indicator. It should be noted that the server A and the server B may be a same server, or may be different servers.

In some cases, to further reduce a computational burden and occupied storage space of the vehicle, the vehicle sends the operation data of the power battery during operation to a server. The server determines the operation fault data feature based on the operation data of the power battery during operation. In addition, as described above, a process of extracting the historical production data feature also occurs in the server, which will not be described in detail again.

S1020: When the historical production data feature matches the early warning indicator, issue early warning prompt information.

Specifically, matching is performed on the obtained historical production data feature and the early warning indicator. If the two match, it indicates that a production process of the power battery in the vehicle is abnormal, and the early warning prompt information is issued. If the two do not match, it indicates that the production process of the power battery in the vehicle is normal, no early warning is needed currently.

In the foregoing early warning method for the vehicle, when the power battery in the vehicle exhibits the operation fault data feature correlated with the target fault type during operation, the historical production data feature of the power battery during production and the target production early warning indicator correlated with the target fault type are obtained. When the historical production data feature matches the target production early warning indicator, the early warning prompt information is issued. The early warning of the vehicle is performed by combining the production data and the operation data throughout the entire life cycle of the battery, enhancing the accuracy of the early warning.

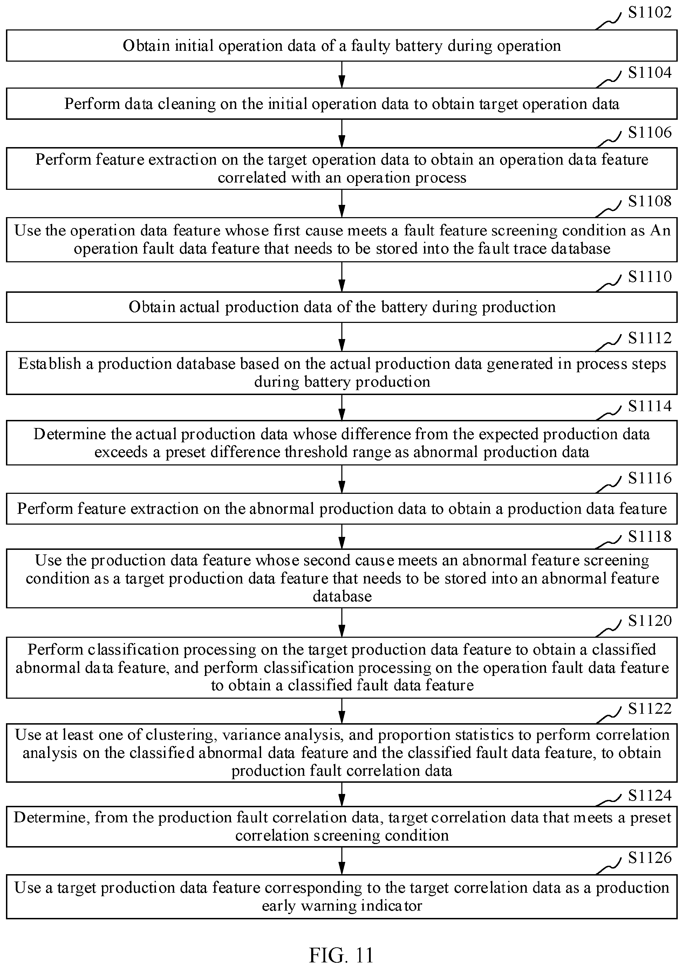

An implementation of this specification further provides a method for creating the early warning indicator. An operation fault data feature is stored into a fault trace database. A target production data feature is stored in the abnormal feature database. For example, with reference to FIG. 11, the method for creating the early warning indicator may include the steps as follows.

S1102: Obtain initial operation data of the faulty battery during operation.

S1104: Perform data cleaning on the initial operation data to obtain target operation data.

S1106: Perform feature extraction on the target operation data to obtain an operation data feature correlated with the operation process.

The operation data feature corresponds to a first cause.

S1108: Use the operation data feature whose first cause meets a fault feature screening condition as an operation fault data feature that needs to be stored into the fault trace database.

S1110: Obtain actual production data of the battery during production.

The actual production data corresponds to expected production data.

S1112: Establish a production database based on the actual production data generated in process steps during battery production.

S1114: Determine the actual production data whose difference from the expected production data exceeds a preset difference threshold range as abnormal production data.

S1116: Perform feature extraction on the abnormal production data to obtain a production data feature.

The production data feature corresponds to a second cause.

S1118: Use the production data feature whose second cause meets an abnormal feature screening condition as a target production data feature that needs to be stored into the abnormal feature database.

The target production data feature is used to characterize a deviation of the actual production data of the battery from the expected production data of the battery.

S1120: Perform classification processing on the target production data feature to obtain a classified abnormal data feature, and perform classification processing on the operation fault data feature to obtain a classified fault data features.

S1122: Use at least one of clustering, variance analysis, and proportion statistics to perform correlation analysis on the classified abnormal data feature and the classified fault data feature, to obtain production fault correlation data.

The production fault correlation data is used to characterize a degree of correlation between the target production data feature and fault types.

S1124: Determine, from the production fault correlation data, target correlation data that meets a preset correlation screening condition.

S1126: Use a target production data feature corresponding to the target correlation data as a production early warning indicator.

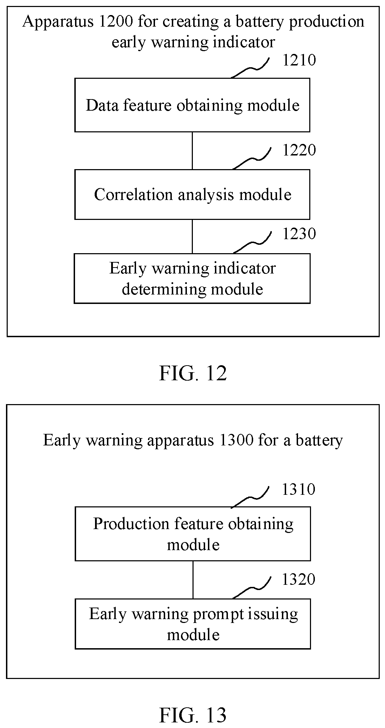

An implementation of this specification provides an apparatus 1200 for creating an early warning indicator. With reference to FIG. 12, the apparatus 1200 for creating an early warning indicator includes: a data feature obtaining module 1210, a correlation analysis module 1220, and an early warning indicator determining module 1230.

The data feature obtaining module 1210 is configured to obtain a target production data feature of a battery during production, and an operation fault data feature of a faulty battery correlated with a fault type during operation.

The correlation analysis module 1220 is configured to perform correlation analysis on the target production data feature and the operation fault data feature to obtain production fault correlation data, where the production fault correlation data is used to characterize a degree of correlation between the target production data feature and the fault type.

The early warning indicator determining module 1230 is configured to determine, based on the production fault correlation data, a production early warning indicator correlated with the fault type from the target production data feature.

An implementation of this specification provides an early warning apparatus 1300 for a battery. With reference to FIG. 13, the early warning apparatus 1300 for a battery includes: a production feature obtaining module 1310 and an early warning prompt issuing module 1320.

The production feature obtaining module 1310 is configured to obtain an actual production data feature of a to-be-evaluated battery during production.

The early warning prompt issuing module 1320 is configured to issue early warning prompt information when the actual production data feature of the to-be-evaluated battery matches an early warning indicator, where a method for creating the early warning indicator includes:
performing correlation analysis on sample production data and sample operation fault data of a preset sample battery to obtain production fault correlation data, where there are a plurality of preset sample batteries; and
when the production fault correlation data is greater than a predetermined threshold, the early warning indicator is determined based on the sample production data corresponding to the sample operation fault data.

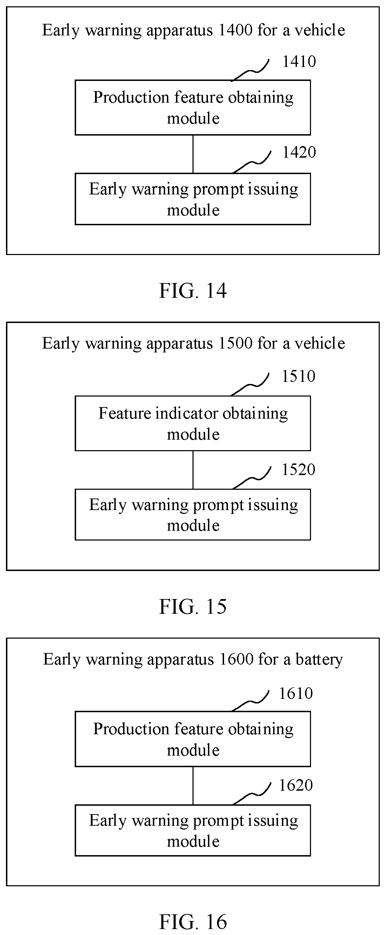

An implementation of this specification provides an early warning apparatus 1400 for a vehicle. With reference to FIG. 14, the early warning apparatus 1400 for a vehicle includes: a production feature obtaining module 1410 and an early warning prompt issuing module 1420.

The production feature obtaining module 1410 is configured to: when a power battery in a vehicle exhibits an operation fault data feature correlated with a fault type during operation, obtain a historical production data feature of the power battery during production.

The early warning prompt issuing module 1420 is configured to issue early warning prompt information when the historical production data feature matches the production early warning indicator correlated with the fault type, where the production early warning indicator is obtained according to the method described in any one of the foregoing implementations.

An implementation of this specification provides an early warning apparatus 1500 for a vehicle. With reference to FIG. 15, the early warning apparatus 1500 for a vehicle includes: a feature indicator obtaining module 1510 and an early warning prompt issuing module 1520.

The feature indicator obtaining module 1510 is configured to: when a power battery in a vehicle exhibits an operation fault data feature correlated with a target fault type during operation, obtain a historical production data feature of the power battery during production and a target production early warning indicator correlated with the target fault type.

The early warning prompt issuing module 1520 is configured to: when the historical production data feature matches the target production early warning indicator, issue early warning prompt information.

An implementation of this specification provides an early warning apparatus 1600 for a battery. With reference to FIG. 16, the early warning apparatus 1600 for a battery includes: a production feature obtaining module 1610 and an early warning prompt issuing module 1620.

The production feature obtaining module 1610 is configured to obtain an actual production data feature of a to-be-evaluated battery during production.

The early warning prompt issuing module 1620 is configured to issue early warning prompt information when the actual production data feature of the to-be-evaluated battery matches a production early warning indicator, where the production early warning indicator is obtained according to the method described in any one of the foregoing implementations.

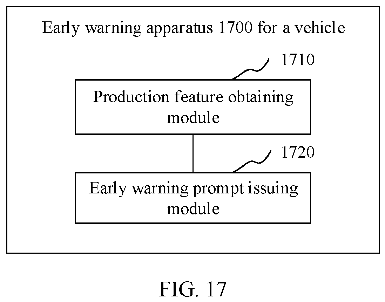

An implementation of this specification provides an early warning apparatus 1700 for a vehicle. The vehicle includes a power battery. With reference to FIG. 17, the early warning apparatus 1700 for a vehicle includes: a production feature obtaining module 1710 and an early warning prompt issuing module 1720.

The production feature obtaining module 1710 is configured to obtain a historical production data feature of the power battery during production.

The early warning prompt issuing module 1720 is configured to match the historical production data feature with an early warning indicator, and if the matching is successful, issues a corresponding early warning signal to the vehicle, so that the vehicle issues early warning prompt information based on the early warning signal. A method for creating the early warning indicator includes:
performing correlation analysis on sample production data and sample operation fault data of a preset sample battery to obtain production fault correlation data, where there are a plurality of preset sample batteries; and
when the production fault correlation data is greater than a predetermined threshold, based on the sample production data corresponding to the sample operation fault data.

For specific descriptions of the early warning indicator creation apparatus, the early warning apparatus for a battery, and the early warning apparatus for a vehicle, reference can be made to the foregoing descriptions of the indicator creation method, the early warning indicator creation method, the battery early warning method, and the vehicle early warning method, which will not be described in detail again. Each module in the foregoing apparatuses may be implemented by using software, hardware, or any combination thereof. The foregoing modules may be embedded in or independent of a processor in a computer device in a form of hardware, or may be stored into a memory in the computer device in a form of software, so that the processor can invoke and perform operations corresponding to the foregoing modules.

An implementation of this specification provides a server, including a memory and a processor. The memory stores a computer program. When the processor executes the computer program, steps of the method according to any one of the foregoing implementations are implemented.

An implementation of this specification provides a vehicle, including a memory and a processor. The memory stores a computer program. When the processor executes the computer program, steps of the method according to any one of the foregoing implementations are implemented.

It should be noted that the logic and/or steps represented in the flowcharts or otherwise described herein, for example, can be considered as a sequenced list of executable instructions for implementing logical functions, and can be specifically implemented in any computer readable medium for use by, or in conjunction with, instruction execution systems, apparatuses, or devices (such as computer-based systems, systems including processors, or other systems that can fetch and execute instructions from instruction execution systems, apparatuses, or devices). For purposes of this specification, the "computer-readable medium" may be any apparatus that can contain, store, communicate, propagate, or transmit a program for use by, or in conjunction with an instruction execution system, apparatus, or device. More specific examples (non-exhaustive list) of computer-readable media include: an electrical connection portion (electronic apparatus) having one or more wires, a portable computer enclosure (magnetic apparatus), a random access memory (RAM), a read-only memory (ROM), an erasable and editable read-only memory (EPROM or flash memory), a fiber optic apparatus, and a portable compact disc read-only memory (CDROM). In addition, the computer-readable medium may even be paper or other suitable medium on which a program can be printed, because the program may be obtained electronically, for example, by optical scanning of the paper or other medium, followed by editing, interpretation or other suitable processing as necessary, and then stored into a computer memory.

## Claims

1. An early warning method for a device, wherein the device comprises a subcomponent, and the early warning method comprises:
obtaining a historical production data feature of the subcomponent during production; and
when the historical production data feature of the subcomponent matches an early warning indicator, issuing early warning prompt information; wherein
the early warning indicator is created by obtaining production fault correlation data based on sample production data and sample operation fault data of a preset subcomponent sample, and when the production fault correlation data is greater than a predetermined threshold, determining the early warning indicator based on the sample production data corresponding to the sample operation fault data, wherein there are a plurality of preset subcomponent samples.

2. The method according to claim 1, wherein when the historical production data feature of the subcomponent matches the early warning indicator, the early warning prompt information is issued to the subcomponent.

3. The method according to claim 1, wherein the device is an electric energy device, the subcomponent is a battery, and the preset subcomponent sample is a preset sample battery; and before performing correlation analysis on the sample production data and the sample operation fault data of the preset subcomponent sample, the method further comprises:
obtaining actual sample production data of the preset sample battery during production, wherein the actual sample production data corresponds to expected sample production data; and
determining abnormal production data from the actual sample production data as the sample production data based on a comparison result between the actual sample production data and the expected sample production data.

4. The method according to claim 3, wherein a method for determining the abnormal production data comprises at least one of the following steps:
determining the actual sample production data different from the expected sample production data as the abnormal production data; or
determining the actual sample production data whose difference from the expected sample production data exceeds a preset difference threshold range as the abnormal production data.

5. The method according to claim 3, wherein performing correlation analysis on the sample production data and the sample operation fault data of the preset subcomponent sample comprises:
performing feature extraction on the abnormal production data to obtain a target production data feature; and
performing correlation analysis on the target production data feature and the sample operation fault data to obtain the production fault correlation data.

6. The method according to claim 5, wherein after performing feature extraction on the abnormal production data, the method further comprises:
performing feature extraction on the abnormal production data to obtain an abnormal production data feature; and
screening out the abnormal production data feature that meets a first preset screening condition as the target production data feature.

7. The method according to claim 5 or 6, wherein before performing correlation analysis on the sample production data and the sample operation fault data of the preset subcomponent sample, the method further comprises:
obtaining a sample operation fault data feature from a sample fault trace database as the sample operation fault data.

8. The method according to claim 7, wherein a method for constructing the sample fault trace database comprises:
obtaining an operation data feature of a faulty battery during operation, wherein the faulty battery is the preset sample battery on which a fault occurs during operation;
screening out the operation data feature that meets a second preset screening condition as the sample operation fault data feature; and
storing the sample operation fault data feature into the sample fault trace database.

9. The method according to claim 8, wherein obtaining the operation data feature of the faulty battery during operation comprises:
obtaining initial operation data of the faulty battery during operation;
performing data cleaning on the initial operation data to obtain target operation data; and
performing feature extraction on the target operation data to obtain the operation data feature.

10. The method according to claim 7, wherein after obtaining the target production data feature, the method comprises:
performing classification processing on the target production data feature to obtain a classified abnormal data feature; and
after obtaining the sample operation fault data feature, the method comprises:
performing classification processing on the sample operation fault data feature to obtain a classified fault data feature; and
performing correlation analysis on the classified abnormal data feature and the classified fault data feature to obtain the production fault correlation data.

11. The method according to any one of claims 1 to 6 and claims 8 to 10, wherein an analysis method for performing correlation analysis to obtain the production fault correlation data comprises at least one of clustering, variance analysis, and proportion statistics.

12. An early warning method, applied to a network device, for an electric energy device, wherein the electric energy device comprises a battery, and the method comprises:
obtaining a historical production data feature of the battery during production; and
matching the historical production data feature with an early warning indicator, and when the matching is successful, issuing a corresponding early warning signal to the electric energy device, so that the electric energy device issues early warning prompt information based on the early warning signal; and a method for creating the early warning indicator comprises:
performing correlation analysis on sample production data and sample operation fault data of a preset sample battery to obtain production fault correlation data, wherein there are a plurality of preset sample batteries; and
when the production fault correlation data is greater than a predetermined threshold, determining an early warning indicator based on the sample production data corresponding to the sample operation fault data.

13. An early warning method, applied to an electric energy device, wherein the electric energy device comprises a battery, and the method comprises:
receiving an early warning signal sent by a network device, and issuing corresponding early warning prompt information based on the early warning signal, wherein the early warning signal is determined by the network device based on a matching status between a historical production data feature of the battery and an early warning indicator, and a method for creating the early warning indicator comprises:
performing correlation analysis on sample production data and sample operation fault data of preset sample battery to obtain production fault correlation data, wherein there are a plurality of preset sample batteries; and
when the production fault correlation data is greater than a predetermined threshold, determining an early warning indicator based on the sample production data corresponding to the sample operation fault data.

14. An early warning method, applied to an electric device, wherein the electric device comprises a battery, the electric device stores a historical production data feature of the battery, and the method comprises:
receiving an early warning indicator sent by a network device; and
matching the historical production data feature with the early warning indicator, and when the matching is successful, issuing corresponding early warning prompt information; and
a method for creating the early warning indicator comprises:
performing correlation analysis on sample production data and sample operation fault data of preset sample battery to obtain production fault correlation data, wherein there are a plurality of preset sample batteries; and
when the production fault correlation data is greater than a predetermined threshold, determining an early warning indicator based on the sample production data corresponding to the sample operation fault data.

15. A network device, comprising a memory and a processor, wherein the memory stores a computer program, and when the processor executes the computer program, the method according to any one of claims 1 to 12 is implemented.

16. An electric energy device, comprising a memory and a processor, wherein the memory stores a computer program, and when the processor executes the computer program, the method according to claim 13 or 14 is implemented.

17. The electric energy device according to claim 16, wherein the electric energy device is a vehicle, a ship, or an aircraft.

18. A computer-readable storage medium, wherein when instructions in the computer-readable storage medium are executed by a processor of an electronic device, the electronic device is enabled to perform the method according to any one of claims 1 to 14.

19. A computer program product, comprising a computer program, wherein when the computer program is executed by a processor, the method according to any one of claims 1 to 14 is implemented.

20. An early warning apparatus for a battery, wherein the apparatus comprises:
a production feature obtaining module, configured to obtain an actual production data feature of a to-be-evaluated battery during production; and
an early warning prompt issuing module, configured to issue early warning prompt information when the actual production data feature of the to-be-evaluated battery matches an early warning indicator, wherein a method for creating the early warning indicator comprises:
performing correlation analysis on sample production data and sample operation fault data of preset sample battery to obtain production fault correlation data, wherein there are a plurality of preset sample batteries; and
when the production fault correlation data is greater than a predetermined threshold, determining an early warning indicator based on the sample production data corresponding to the sample operation fault data.

21. An early warning apparatus for a vehicle, wherein the vehicle comprises a power battery, and the apparatus comprises:
a production feature obtaining module, configured to obtain a historical production data feature of the power battery during production; and
an early warning prompt issuing module, configured to: match the historical production data feature with an early warning indicator, and when the matching is successful, issue a corresponding early warning signal to the vehicle, to enable the vehicle to issue early warning prompt information based on the early warning signal; and a method for creating the early warning indicator comprises:
performing correlation analysis on sample production data and sample operation fault data of preset sample battery to obtain production fault correlation data, wherein there are a plurality of preset sample batteries; and
when the production fault correlation data is greater than a predetermined threshold, determining an early warning indicator based on the sample production data corresponding to the sample operation fault data.
